# EUROPEAN PATENT APPLICATION

(11) **EP 4 804 598 A1**
(43) Date of publication of application: **09.09.2026**
(21) Application number: 26161804.5
(22) Date of filing: 03.03.2026
(51) Int. Cl.: H04W 24/02, H04W 16/22, G06F 30/20, G06F 30/27, H04L 41/14, H04L 41/0895, H04W 24/06

(54) **DIGITAL TWIN IN COMMUNICATIONS**

(30) Priority: 03.03.2025 FI 20255178
(71) Applicant: Nokia Solutions and Networks Oy, 02610 Espoo (FI)
(72) Inventor: MOISIO, Martti Johannes, Perttula (FI); UUSITALO, Mikko Aleksi, Helsinki (FI); UPADHYA, Karthik, Bangalore (IN)
(74) Representative: Nokia EPO representatives

(57) **Abstract**

An apparatus including at least one processor, and at least one memory storing instructions that, when executed by the at least one processor, cause the apparatus at least to: apply a digital twin assistance mode, based on a digital twin assistance message received by the apparatus from a network node; receive, from the network node, a digital twin assistance information element; and based on the digital twin assistance information element, change a default behaviour to cause a digital twin assisted behaviour in order to modify a network operation, the digital twin assisted behaviour representing an operation or a process associated with a digital twin assisted mode.

## Description

### FIELD

The following example embodiments relate to wireless communication.

### BACKGROUND

A large part of handovers in a wireless radio network take place in a non-optimal manner in terms of time and location.

### SUMMARY

The scope of protection sought for various example embodiments is set out by the independent claims. The example embodiments and features, if any, described in this specification that do not fall under the scope of the independent claims are to be interpreted as examples useful for understanding various embodiments.

According to a first aspect, there is provided a method comprising:
applying, by an apparatus, a digital twin assistance mode, based on a digital twin assistance message received by the apparatus from a network node;
receiving, by the apparatus from the network node, a digital twin assistance information element; and
based on the digital twin assistance information element, changing by the apparatus a default behaviour to cause a digital twin assisted behaviour in order to modify a network operation, wherein the digital twin assisted behaviour represents an operation or a process associated with a digital twin assisted mode.

According to a second aspect, there is provided a method comprising:
transmitting, by a network node to an apparatus, a digital twin assistance message to request the apparatus to apply a digital twin assistance mode; and
based upon the apparatus accepting to apply the digital twin assistance mode,
forwarding, by the network node to the apparatus, a digital twin assistance information element.

According to a third aspect, there is provided a method comprising:
receiving, by a terminal device from an apparatus, a request message requesting the terminal device to enter a digital twin assisted mode;
determining, by the terminal device, whether to enter the digital twin assisted mode enabling a digital twin assisted action parameter for the terminal device.

According to a fourth aspect, there is provided an apparatus comprising means for causing the apparatus to perform at least the method of the first aspect.

According to a fifth aspect, there is provided an apparatus comprising at least one processor, and at least one memory storing instructions that, when executed by the at least one processor, cause the apparatus to perform at least the method of the first aspect.

According to a sixth aspect, there is provided a network node comprising means for causing the network node to perform at least the method of the second aspect.

According to a seventh aspect, there is provided a network node comprising at least one processor, and at least one memory storing instructions that, when executed by the at least one processor, cause the network node to perform at least the method of the second aspect.

According to an eighth aspect, there is provided a terminal device comprising means for causing the terminal device to perform at least the method of the third aspect.

According to a ninth aspect, there is provided a terminal device comprising at least one processor, and at least one memory storing instructions that, when executed by the at least one processor, cause the terminal device to perform at least the method of the third aspect.

According to a tenth aspect, there is provided a non-transitory computer readable medium comprising program instructions which, when executed by an apparatus, cause the apparatus to perform at least the method of the first aspect.

According to an eleventh aspect, there is provided a non-transitory computer readable medium comprising program instructions which, when executed by a network node, cause the network node to perform at least the method of the second aspect.

According to a twelfth aspect, there is provided a non-transitory computer readable medium comprising program instructions which, when executed by a terminal device, cause the terminal device to perform at least the method of the third aspect.

According to a thirteenth aspect, there is provided a computer readable medium comprising instructions stored thereon that, when executed by a processor, perform the method of any of the first to third aspects.

### BRIEF DESCRIPTION OF THE DRAWINGS

In the following, various example embodiments will be described in greater detail with reference to the accompanying drawings, in which
FIG. 1 illustrates an example of a wireless communication network;
FIGs. 2 to 4 illustrate signal flow diagrams according to an exemplary embodiment;
FIGs. 5 to 7 illustrate flow charts according to an exemplary embodiment;
FIGs. 8 to 10 illustrate exemplary apparatuses.

### DETAILED DESCRIPTION

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments within the scope of the claims. Furthermore, the words "comprising" and "including" should be understood as not limiting the described embodiments to consist of only those features that have been mentioned, and such embodiments may also contain features that have not been specifically mentioned. Reference numbers, in the description and/or in the claims, serve to illustrate the embodiments with reference to the drawings, without limiting the embodiments to these examples only.

Some example embodiments described herein may be implemented in a wireless communication network comprising a radio access network based on one or more of the following radio access technologies (RATs): global system for mobile communications (GSM) or any other second generation (2G) radio access technology, universal mobile telecommunication system (UMTS, 3G) based on basic wideband-code division multiple access (W-CDMA), high-speed packet access (HSPA), long term evolution (LTE), LTE-Advanced, fourth generation (4G), fifth generation (5G), 5G new radio (NR), 5G-Advanced (i.e., 3GPP NR Rel-18 and beyond), sixth generation (6G), or seventh generation (7G). Some examples of radio access networks include the universal mobile telecommunications system (UMTS) radio access network (UTRAN), the evolved universal terrestrial radio access network (E-UTRA), or the next generation radio access network (NG-RAN). The wireless communication network may further comprise a core network, and some example embodiments may also be applied to network functions of the core network.

It should be noted that the embodiments are not restricted to the wireless communication network given as an example, but a person skilled in the art may also apply the solution to other wireless communication networks or systems provided with necessary properties. For example, some example embodiments may also be applied to a communication system based on IEEE 802.11 specifications, or a communication system based on IEEE 802.15 specifications. IEEE is an abbreviation for the Institute of Electrical and Electronics Engineers.

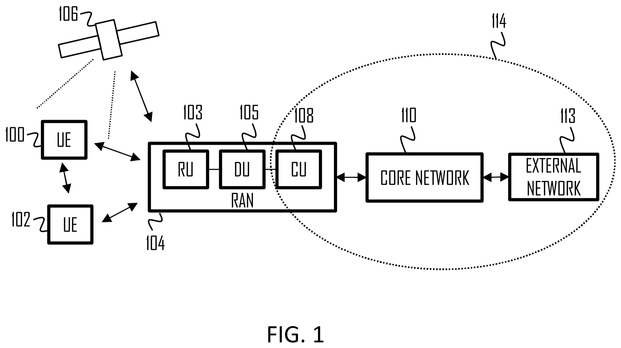

FIG. 1 depicts an example of a simplified wireless communication network showing some physical and logical entities. The connections shown in FIG. 1 may be physical connections or logical connections. It is apparent to a person skilled in the art that the wireless communication network may also comprise other physical and logical entities than those shown in FIG. 1.

The example embodiments described herein are not, however, restricted to the wireless communication network given as an example but a person skilled in the art may apply the example embodiments described herein to other wireless communication networks provided with necessary properties.

The example wireless communication network shown in FIG. 1 includes a radio access network (RAN) and a core network 110.

FIG. 1 shows user equipment (UE) 100, 102 configured to be in a wireless connection on one or more communication channels in a radio cell with an access node 104 of a radio access network.

The access node 104 may comprise a computing device configured to control the radio resources of the access node 104 and to be in a wireless connection with one or more UEs 100, 102. The access node 104 may also be referred to as a base station, a base transceiver station (BTS), an access point, a cell site, a network node, a radio access network node, a RAN node, or a network device.

The access node 104 may be, for example, an evolved NodeB (abbreviated as eNB or eNodeB), or a next generation evolved NodeB (abbreviated as ng-eNB), or a next generation NodeB (abbreviated as gNB or gNodeB), providing the radio cell. The access node 104 may include or be coupled to transceivers. From the transceivers of the access node 104, a connection may be provided to an antenna unit that establishes a bi-directional radio link to one or more UEs 100, 102. The antenna unit may comprise an antenna or antenna element, or a plurality of antennas or antenna elements.

The wireless connection (e.g., radio link) from a UE 100, 102 to the access node 104 may be called uplink (UL) or reverse link, and the wireless connection (e.g., radio link) from the access node 104 to the UE 100, 102 may be called downlink (DL) or forward link. A UE 100 may also communicate directly with another UE 102, and vice versa, via a wireless connection generally referred to as a sidelink (SL). It should be appreciated that the access node 104 or its functionalities may be implemented by using any node, host, server, access point or other entity suitable for providing such functionalities.

The radio access network may comprise more than one access node 104, in which case the access nodes may also be configured to communicate with one another over wired or wireless links. These links between access nodes may be used for sending and/or receiving control plane signaling and also for routing data from one access node to another access node.

The access node 104 may further be connected to a core network (CN) 110. The core network 110 may comprise an evolved packet core (EPC) network and/or a 5th generation core network (5GC). The EPC may comprise network entities, such as a serving gateway (S-GW for routing and forwarding data packets), a packet data network gateway (P-GW) for providing connectivity of UEs to external packet data networks, and/or a mobility management entity (MME). The 5GC may comprise one or more network functions, such as at least one of: a user plane function (UPF), an access and mobility management function (AMF), a location management function (LMF), and/or a session management function (SMF).

The core network 110 may also be able to communicate with one or more external networks 113, such as a public switched telephone network or the Internet, or utilize services provided by them. For example, in 5G wireless communication networks, the UPF of the core network 110 may be configured to communicate with an external data network via an N6 interface. In LTE wireless communication networks, the P-GW of the core network 110 may be configured to communicate with an external data network.

It should also be understood that the distribution of functions between core network operations and access node operations may differ in future wireless communication networks compared to that of the LTE or 5G, or even be non-existent.

The illustrated UE 100, 102 is one type of an apparatus to which resources on the air interface may be allocated and assigned. The UE 100, 102 may also be called a wireless communication device, a subscriber unit, a mobile station, a remote terminal, an access terminal, a user terminal, a terminal device, or a user device, just to mention but a few names. The UE 100, 102 may be a computing device operating with or without a subscriber identification module (SIM), including, but not limited to, the following types of computing devices: a mobile phone, a smartphone, a personal digital assistant (PDA), a handset, a computing device comprising a wireless modem (e.g., an alarm or measurement device, etc.), a laptop computer, a desktop computer, a tablet, a game console, a notebook, a multimedia device, a reduced capability (RedCap) device, a wearable device (e.g., a watch, earphones or eyeglasses) with radio parts, a sensor comprising a wireless modem, or a computing device comprising a wireless modem integrated in a vehicle.

It should be appreciated that the UE 100, 102 may also be a nearly exclusive uplink-only device, of which an example may be a camera or video camera loading images or video clips to a network. The UE 100, 102 may also be a device having capability to operate in an Internet of Things (IoT) network, which is a scenario in which objects may be provided with the ability to transfer data over a network without requiring human-to-human or human-to-computer interaction.

The wireless communication network may also be able to support the usage of cloud services. For example, at least part of core network operations may be carried out as a cloud service (this is depicted in FIG. 1 by "cloud" 114). The UE 100, 102 may also utilize the cloud 114. In some applications, the computation for a given UE may be carried out in the cloud 114 or in another UE.

The wireless communication network may also comprise a central control entity, such as a network management system (NMS), or the like. The NMS is a centralized suite of software and hardware used to monitor, control, and administer the network infrastructure. The NMS is responsible for a wide range of tasks such as fault management, configuration management, security management, performance management, and accounting management. The NMS enables network operators to efficiently manage and optimize network resources, ensuring that the network delivers high performance, reliability, and security.

5G enables using multiple-input and multiple-output (MIMO) antennas in the access node 104 and/or the UE 100, 102, many more base stations or access nodes than an LTE network (a so-called small cell concept), including macro sites operating in co-operation with smaller stations and employing a variety of radio technologies depending on service needs, use cases and/or spectrum available. 5G wireless communication networks may support a wide range of use cases and related applications including video streaming, augmented reality, different ways of data sharing and various forms of machine-type applications, such as (massive) machine-type communications (mMTC), including vehicular safety, different sensors and real-time control.

In 5G wireless communication networks, access nodes and/or UEs may have multiple radio interfaces, such as below 6 gigahertz (GHz), centimeter wave (cmWave) and millimeter wave (mmWave), and also being integrable with legacy radio access technologies, such as LTE. Integration with LTE may be implemented, for example, as a system, where macro coverage may be provided by LTE, and 5G radio interface access may come from small cells by aggregation to LTE. In other words, a 5G wireless communication network may support both inter-RAT operability (such as interoperability between LTE and 5G) and inter-RI operability (inter-radio interface operability, such as between below 6GHz, cmWave, and mmWave).

5G wireless communication networks may also apply network slicing, in which multiple independent and dedicated virtual sub-networks (network instances) may be created within the same physical infrastructure to run services that have different requirements on latency, reliability, throughput and mobility.

In one embodiment, an access node 104 may comprise: a radio unit (RU) 103 comprising a radio transceiver (TRX), i.e., a transmitter (Tx) and a receiver (Rx); one or more distributed units (DUs) 105 that may be used for the so-called Layer 1 (L1) processing and real-time Layer 2 (L2) processing; and a central unit (CU) 108 (also known as a centralized unit) that may be used for non-real-time L2 and Layer 3 (L3) processing. The CU 108 may be connected to the one or more DUs 105 for example via an F1 interface. Such an embodiment of the access node 104 may enable the centralization of CUs relative to the cell sites and DUs, whereas DUs may be more distributed and may even remain at cell sites. The CU and DU together may also be referred to as baseband or a baseband unit (BBU). The CU and DU may also be comprised in a radio access point (RAP).

The CU 108 may be a logical node hosting radio resource control (RRC), service data adaptation protocol (SDAP) and/or packet data convergence protocol (PDCP), of the NR protocol stack for an access node 104. The CU 108 may comprise a control plane (CU-CP), which may be a logical node hosting the RRC and the control plane part of the PDCP protocol of the NR protocol stack for the access node 104. The CU 108 may further comprise a user plane (CU-UP), which may be a logical node hosting the user plane part of the PDCP protocol and the SDAP protocol of the CU for the access node 104.

The DU 105 may be a logical node hosting radio link control (RLC), medium access control (MAC) and/or physical (PHY) layers of the NR protocol stack for the access node 104. The operations of the DU 105 may be at least partly controlled by the CU 108. It should also be understood that the distribution of functions between the DU 105 and the CU 108 may vary depending on the implementation.

Cloud computing systems may also be used to provide the CU 108 and/or DU 105. A CU provided by a cloud computing system may be referred to as a virtualized CU (vCU). In addition to the vCU, there may also be a virtualized DU (vDU) provided by a cloud computing system. Furthermore, there may also be a combination, where the DU may be implemented on so-called bare metal solutions, for example application-specific integrated circuit (ASIC) or customer-specific standard product (CSSP) system-on-a-chip (SoC).

Edge cloud may be brought into the radio access network by utilizing network function virtualization (NFV) and software defined networking (SDN). Using edge cloud may mean access node operations to be carried out, at least partly, in a computing system operationally coupled to a remote radio head (RRH) or a radio unit (RU) 103 of an access node 104. It is also possible that access node operations may be performed on a distributed computing system or a cloud computing system located at the access node 104. Application of cloud RAN architecture enables RAN real-time functions being carried out at the radio access network (e.g., in a DU 105), and non-real-time functions being carried out in a centralized manner (e.g., in a CU 108).

5G (or new radio, NR) wireless communication networks may support multiple hierarchies, where multi-access edge computing (MEC) servers may be placed between the core network 110 and the access node 104. It should be appreciated that MEC may be applied in LTE wireless communication networks as well.

A 5G wireless communication network ("5G network") may also comprise a non-terrestrial communication network, such as a satellite communication network, to enhance or complement the coverage of the 5G radio access network. For example, satellite communication may support the transfer of data between the 5G radio access network and the core network 110, enabling more extensive network coverage. Possible use cases may include: providing service continuity for machine-to-machine (M2M) or Internet of Things (IoT) devices or for passengers on board of vehicles, or ensuring service availability for critical communications, and future railway, maritime, or aeronautical communications. Satellite communication may utilize geostationary earth orbit (GEO) satellite systems, or low earth orbit (LEO) satellite systems, such as mega-constellations (i.e., systems in which hundreds of (nano)satellites are deployed). Alternatively, the satellites may be an airborne devices, such as an unmanned aerial vehicle (UAV), or a high-altitude platform system (HAPS). A given satellite 106 may provide communication services on Earth via one or more satellite beams. The one or more satellite beams create one or more cells over a given service area that may be bounded by the field of view of the satellite 106.

It is obvious for a person skilled in the art that the access node 104 depicted in FIG. 1 is just an example of a part of a radio access network, and in practice the radio access network may comprise a plurality of access nodes 104, the UEs 100, 102 may have access to a plurality of radio cells, and the radio access network may also comprise other apparatuses, such as physical layer relay access nodes or other entities. At least one of the access nodes may be a Home eNodeB or a Home gNodeB. A Home gNodeB or a Home eNodeB is a type of access node that may be used to provide indoor coverage inside a home, office, or other indoor environment.

Additionally, in a geographical area of a radio access network, a plurality of different kinds of radio cells as well as a plurality of radio cells may be provided. Radio cells may be macro cells (or umbrella cells) which may be large cells having a diameter of up to tens of kilometers, or smaller cells such as micro-, femto- or picocells. The access node(s) 104 of FIG. 1 may provide any kind of these cells. A cellular radio network may be implemented as a multilayer access networks including several kinds of radio cells. In multilayer access networks, one access node may provide one kind of a radio cell or radio cells, and thus a plurality of access nodes may be needed to provide such a multilayer access network.

For fulfilling the need for improving performance of radio access networks, the concept of "plug-and-play" access nodes may be introduced. A radio access network, which may be able to use "plug-and-play" access nodes, may include, in addition to Home eNodeBs or Home gNodeBs, a Home Node B gateway (HNB-GW) (not shown in FIG. 1). An HNB-GW, which may be installed within an operator's radio access network, may aggregate traffic from a large number of Home eNodeBs or Home gNodeBs back to a core network 110 of the operator.

6G wireless communication networks are expected to adopt flexible decentralized and/or distributed computing systems and architecture and ubiquitous computing, with local spectrum licensing, spectrum sharing, infrastructure sharing, and intelligent automated management underpinned by mobile edge computing, artificial intelligence, short-packet communication and blockchain technologies. Key features of 6G may include intelligent connected management and control functions, programmability, integrated sensing and communication, reduction of energy footprint, trustworthy infrastructure, scalability and affordability. In addition to these, 6G is also targeting new use cases covering the integration of localization and sensing capabilities into system definition to unifying user experience across physical and digital worlds.

A radio aware digital twin (RADT) may be a digital twin which may be a virtual copy of a wireless radio network. The RADT may model transmitting and/or receiving network nodes and their properties such as position and/or trajectories. The RADT may know or query from the radio access network details such as base station and/or terminal device capabilities, beam patterns and/or radio resource management algorithms. The RADT may maintain a database such as a radio environment map (REM) on link quality in the whole network with some resolution, for example, average RSRP/SINR (reference signal received power/signal to noise ratio) level 5 m x 5 m grid. The database may be regularly updated.

There may be a 3-dimensional digital twin representation of an area where a cellular network is in operation. At least buildings in the area may be known, and preferably also roads, terrain, ground height, terrain type (e.g. vegetation) etc. Information on the network topology may be maintained. The level of accuracy provided by a typical map data provider may be sufficient, such as OpenStreetMap, Google Maps, etc. The map data may be represented by a hierarchical data structure, such as JSON, or its variants, such as GeoJSON. There may be more advanced formats also, for example, USD (Universal Scene Description) which may be used for realistic scenarios especially for Metaverse use cases. Information on the properties of base stations and antennas may be described in hierarchical data formats, for example. Propagation may be calculated in advance, for example, by ray-tracing.

The digital twin representation of the area where the wireless network is operating may provide additional information which may be used to optimize radio network operation. The information may include terrain/topology representation of the area, which may be similar to that of Google Maps etc., and be able to show roads, terrain height, etc. Advanced information may include such as vegetation which may affect the propagation. The information may include a 3D representation of the buildings in the area, typically represented with 3D polygons (same technique may be used in games, for example). Also, surface material(s) may be important from the propagation calculation point of view. The information may include exact locations of the base station cells and their antenna properties, including boresight direction, tilt angles, etc., locations of the terminal devices (UE). The better the UE location is known, the better the concept may work. Also, especially with higher frequencies with UE antenna panels, the rotation of the UE along its all 3 axes may matter. This may relate to a 6D position.

Basic information on the network topology may be received from various map providers. It may be further enhanced by dedicated measurements, using, for example, lidars (attached to cars, drones etc.). Joint communication and sensing (JCAS) technology may involve using wireless signals also to sense the environment, so that it may be possible to detect obstacles, blockers, etc. This technology is similar to radar and lidar technology, and thus data on the network topology may be obtained even without any external map data.

The radio-aware digital twin may also know the properties of the RAN, for example: base station antenna array configuration, beam management support, i.e. what kind of beams are available, other capabilities such as MIMO, sidelink support, supported 3GPP releases, etc. Anything that may be sent from the base station to terminal device, for example, as part of a RRC configuration, may be useful. Beyond 3GPP configuration, and knowledge of vendor specific algorithms such as link adaptation, scheduling, power control, etc., may be useful.

Other information outside of the RAN may include, for example the following: UE trajectories and speed which may be even known in some industrial use cases (e.g. AGVs moving on factory floor), possible blockers and clutter information which may impact radio propagation, information on traffic and load, machine-generated traffic may have a known pattern, user distribution, temporal and spatial hotspots

There are various variants of inter-gNB cell-level mobility, such as inter-gNB and conditional HO, but they each contain the basic steps such as measurement reporting, HO requests and commands and RRC reconfiguration messages. For 3GPP Release 18, there is active work to define L1/L2 triggered mobility (LTM). In LTM, the goal is to enable cell changes with L1/L2 signaling which may reduce latency, overhead and interruption time. LTM may configure and maintain a list of multiple candidate cells and allow fast switching between the cells. In LTM, the serving gNB-CU may identify the potential targets based on L3 measurement reports, prepare the target cells, and send to the UE the target cell configurations (early provisions of target cell configurations). There is earlier work for carrying out, for example, a location-based handover. This may be beneficial at least for some specific use cases where the UEs are using the same trajectories, for example, when the users are on railway trains.

An embodiment may be applied to cell-level mobility in 3GPP, 5G and future 6G systems. It may also be applied to beam-level mobility.

An embodiment may be able to optimize the right time and place for a handover. An embodiment may be able to avoid carrying out the handover in non-optimal way, for example, too early. An embodiment may enable to avoid a situation where the network operates partly "blindly" without using all the available information that it is able have, especially outside the RAN network.

The inventors conducted measurements (walking tests) within a public LTE network. The measurements may be applicable to 5G as well. It was noticed that a large part of handovers was performed in time and place which are far from optimal. If the handover is done too late, the KPI values (RSRP, RSRQ and SINR) may turn very poor before the handover to the better cell takes place. The handover may be performed too late, if it is relying on outdated and inaccurate information on neighbour cell quality. The network may have no knowledge on the topology, for example, that there is a walking bridge which suddenly blocks the signal. The total handover process may take a long time due to long timers, filters, offset values and excessive signalling needed.

An embodiment enables to use information from the RADT to improve radio network coverage, capacity and quality. For example, a RADT-enabled handover may be performed, but same principles may be applied, for example, for beam selection, resource allocation, and/or power control, as well.

An embodiment enables a signalling framework to use auxiliary (outside RAN) information provided by an accurate representation of the radio aware digital twin, for example, UE location, line-of-sight information between UE and the cells in the area, information on blockage and obstacles (such as buildings) - to optimize the time and place when handover is to be triggered, while at the same time the signalling load may be reduced and energy may be saved at both UE and network side due to reduced measurements and signalling.

In an embodiment, a RADT assistance signalling and information element may be sent from a radio aware digital twin (RADT) node to the radio access network (RAN). In an embodiment, the RADT node may ask from the RAN whether it is able to provide assistance to the RAN. If assistance is granted, the RADT may send auxiliary assistance information to the RAN, for example, related to handover. Each gNB may independently agree with the UEs associated with the gNB that they wish enter to a special RADT-HO mode. The UE may also decline the request even if it is able to support said mode. When in RADT-HO mode, the UE may reduce its measurements and send less measurement reports, since they may be partly replaced by the RADT assistance information. Depending on the confidence and quality of the assistance information in the environment the UE is located, RAN and UE may negotiate between two different operation modes:
∘ Mode 1: Assistance mode - RAN and source gNB may make a HO decision using RADT assistance information.
∘ Mode 2: Command mode - RADT may directly give the HO command. This mode may be beneficial especially in a very controlled and static environment, for example, in a factory with fixed UE trajectories.

An embodiment may be compatible with other handover enhancements, such as conditional handover (CHO) and L1/L2 triggered mobility (LTM).

An embodiment may involve negotiation of a special assistance mode where auxiliary information outside the RAN may be used to replace part of the measurements and/or make handover decisions directly. The signalling framework may support two different modes, assistance mode and command mode. An auxiliary assistance information element may be defined. Information from the RADT may be used to improve radio network coverage, capacity and quality. For example, a RADT-enabled handover, beam selection, resource allocation, and/or power control may be carried out.

In a conventional handover procedure for LTE/NR, based on measurement reports by the UE, the source gNB may decide to prepare a handover (HO) to a target gNB. When acknowledged by the target gNB, the source gNB may send an RRC reconfiguration message to the UE which may initiate a procedure to switch to a new cell and acknowledge that to target gNB and RAN. It is to be noted that this is merely a simplified description of the procedure and does not include details such as RACH/UL grant and path switching.

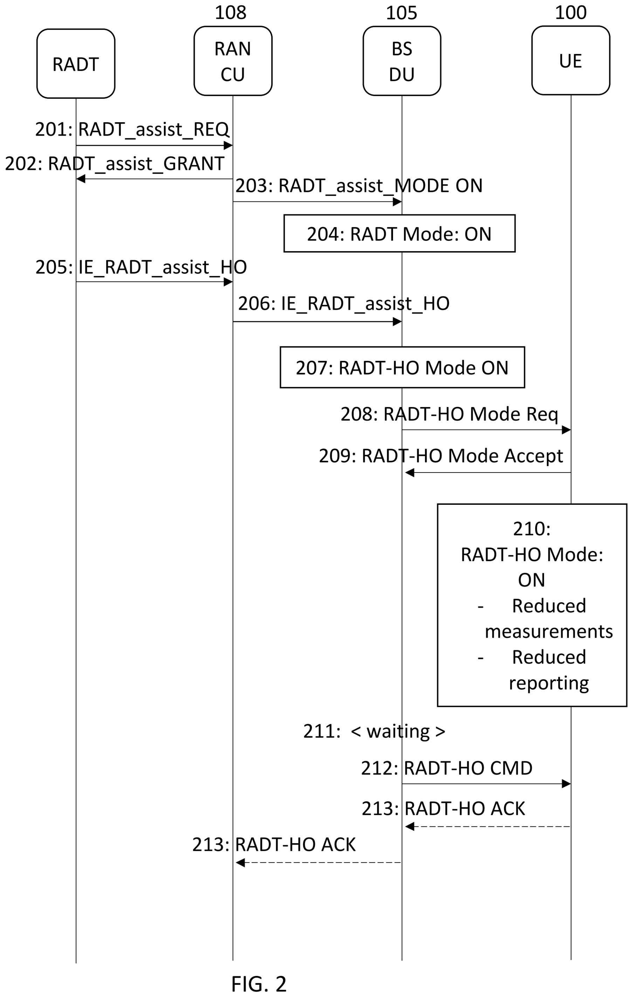

FIG. 2 illustrates a signal flow diagram according to an example embodiment. FIG. 2 illustrates an exemplary signalling flow to enable RADT-based HO. RAN may also be interpreted as CU (central unit) and gNB as DU (distributed unit) according to the functional split with RAN virtualization. The gNB may also be referred to as an access node or a base station (BS).

Referring to FIG. 2, at 201, the RADT node may optionally transmit a request message, such as a RADT assistance request (RADT_assist_REQ) message, to the network node RAN/CU 108 to request, whether the RADT node may provide assistance to the RAN/CU 108. At 202, the network node RAN/CU 108 may optionally grant the assistance by transmitting a grant message, such as a RADT assistance grant (RADT_assist_GRANT) message, to the RADT node.

At 203, the network node RAN/CU 108 may transmit, to an apparatus BS/DU 105, a digital twin assistance message, such as a RADT assistance mode on (RADT_assist_MODE ON) message, to request the apparatus BS/DU 105 to apply a digital twin assistance mode. At 204, the apparatus BS/DU 105 may apply the digital twin assistance mode, based on a digital twin assistance message 203 received by the apparatus BS/DU 105 from the network node RAN/CU 108.

At 205, the network node RAN/CU 108, may receive a digital twin assistance information element, such as a RADT assisted handover information element (IE_RADT_assist_HO). Upon the apparatus BS/DU 105 accepting to apply the digital twin assistance mode, the network node RAN/CU 108 may, at 206, forward the digital twin assistance information element to the apparatus BS/DU 105.

At 207, the apparatus BS/DU 105 may receive, from the network node RAN/CU 108, the digital twin assistance information element, and based on the received digital twin assistance information element, change a default behaviour to cause a digital twin assisted behaviour in order to modify a network operation. In that sense, a default behaviour may refer to or include network operations where such digital twin assistance is not implemented. Exemplarily, a handover operation may be initiated in a different point in time based on implementing and/or applying the digital twin assistance in order to optimize the handover procedure such that a terminal device (i.e. a UE) does not suffer from relatively inferior throughput (e.g. compared to the default handover scheme). The digital twin assisted behaviour may represent an operation or a process associated with a digital twin assisted mode. The digital twin assistance information element may comprise information on a predicted at least one candidate cell for a digital twin assisted handover in a radio environment, and/or confidence level associated with the predicted at least one candidate cell. The predicted at least one candidate cell may be representative of a target cell for a digital twin assisted handover, for example. At 208, the apparatus BS/DU 105 may forward, to a terminal device UE 100, a digital twin assisted mode request, such as a digital twin assisted handover request (e.g. RADT-HO Mode Req), digital twin assisted power control request, digital twin assisted resource allocation request, and/or digital twin assisted beam selection request.

The terminal device UE, 100 may receive, from the apparatus BS/DU 105, the digital twin assisted mode request 209 requesting the terminal device to enter the digital twin assisted mode. The terminal device UE, 100 may determine whether to enter the digital twin assisted mode enabling a digital twin assisted action parameter for the terminal device UE, 100. Upon the terminal device UE, 100 determining to enter the digital twin assisted mode enabling the digital twin assisted action parameter for the terminal device UE, 100, the terminal device UE, 100 may, at 209, transmit to the apparatus BS/DU 105, an acceptance message, such as a digital twin assisted mode accepted message (e.g. RADT-HO Mode Accept). At 210, the terminal device UE, 100 may, while in the digital twin assisted mode (e.g. RADT HO Mode ON), apply reduced downlink signal measurements and reduced downlink signal measurements reporting. After that there may be an optional waiting period 211.

At 212, the apparatus BS/DU 105 may transmit a digital twin command message to the terminal device UE, 100. The digital twin command message may be a digital twin assisted handover command (e.g. RADT-HO CMD), a digital twin assisted power control command, a digital twin assisted resource allocation command, and/or a digital twin assisted beam selection command.

The terminal device UE, 100 may, while in the digital twin assisted mode, perform a handover upon receiving the digital twin assisted handover command from the apparatus BS/DU 105; perform a resource allocation upon receiving the digital twin assisted resource allocation command from the apparatus BS/DU 105; perform a power control upon receiving the digital twin assisted power control command from the apparatus BS/DU 105; and/or perform a beam selection upon receiving the digital twin assisted beam selection command from the apparatus BS/DU 105. Instead of/in addition to handover, resource allocation, power control, and/or beam selection, the command message 212 may relate to some other digital twin assisted operation. At 213, the terminal device UE, 100 may optionally transmit to the apparatus BS/DU 105 an acknowledgement message (e.g. RADT-HO ACK) acknowledging that the terminal device UE, 100 performed the handover, resource allocation, power control, beam selection, and/or other digital twin assisted operation. At 214, the apparatus BS/DU 105 may forward the acknowledgement message to the network node RAN/CU 108.

Thus a RADT assistance signalling and information element may be sent from a digital twin, such as a radio aware digital twin (RADT) node, to the radio access network RAN. In an embodiment, the RADT node may ask from the RAN whether it is able to provide assistance to the RAN. If assistance is granted, the RADT may send auxiliary assistance information to the RAN, for example, related to handover. Each gNB may independently agree with the UEs associated with the gNB that they wish enter to a special RADT-HO mode. The UE may also decline the request, even if it is able to support said mode. When in the RADT assisted mode, e.g. RADT-HO mode, the UE may reduce its measurements and send less measurement reports, since they may be partly replaced by the RADT assistance information.

Thus after getting acceptance from RAN to enable the RADT assistance (items 201 to 203), RADT may start sending information element (IE) messages to RAN, for example, for RADT assisted handovers (item 205). This message may then passed on to one or more cells (item 206). This may trigger the cell to be in a RADT-HO mode. The cell may then inform selected UEs (via e.g. a RRC message) that it would like to start operating in a RADT-HO mode (items 208 to 209). The UE may also decline that if the UE does not support the feature or for other reasons. If accepted, the UE enters RADT HO mode (item 210). The RADT HO mode may mean that the UE may skip some or all its handover-related measurements, related signaling and/or related measurement reports. Instead, the gNB and/or UE may wait for a RADT-HO command from the gNB (items 211 to 212). When the RADT-HO command may arrive, the UE may perform the handover and optionally acknowledge the handover via the gNB to the network node (items 213 to 214). The network node may know that the UE is changing the cell, and the network node may also detect the handover indirectly.

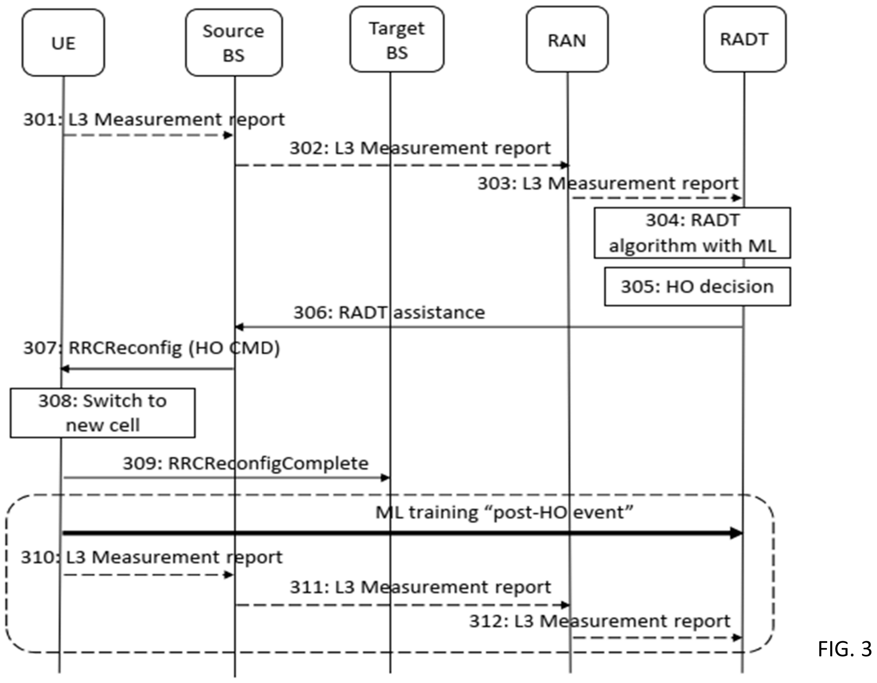

FIG. 3 illustrates a signal flow diagram according to an example embodiment. FIG. 3 illustrates an exemplary signalling flow to enable a digital twin assistance mode and digital twin assisted operation. The RADT may assist a source BS e.g. for a HO decision. It may be up to the BS to make a decision, for example, if, depending on the RADT assistance information provided, the BS has additional local information available, which may make an option to follow a direct command from the RADT to be suboptimal.

Referring to FIG. 3, the terminal device UE, 100 may transmit to the RADT node via the source base station and the network node RAN, a measurement report 301, 302, 303, such as a layer-3 (L3) measurement report. At 304, the RADT node may perform a digital twin algorithm, such as a RADT algorithm; for example, machine learning (ML) and/or artificial intelligence (AI) may be used to learn the radio conditions at the location of the UE in the network. At 305, the RADT node may make a digital twin assistance decision, such as a handover decision. At 306, the RADT node may transmit to the source base station a digital twin assistance message, such as a RADT assistance message. At 307, the source base station may transmit to the terminal device UE, 100 a RRC reconfiguration message, such as a handover command. The terminal device UE, 100 may transmit to the source BS a digital twin acknowledgement message, such as a HO ack message (not shown in Figure 3). At 308, the terminal device UE, 100 may perform a RADT event, such as switching to a new cell by a handover. At 309, the terminal device may transmit to the target cell a RRC reconfiguration complete message, to complete the RADT event. After the RADT event, such as a HO event, the terminal device UE, 100 may perform ML training and transmit to the RADT node via the target base station and the network node RAN, a measurement report 310, 311, 312, such as a layer-3 (L3) measurement report.

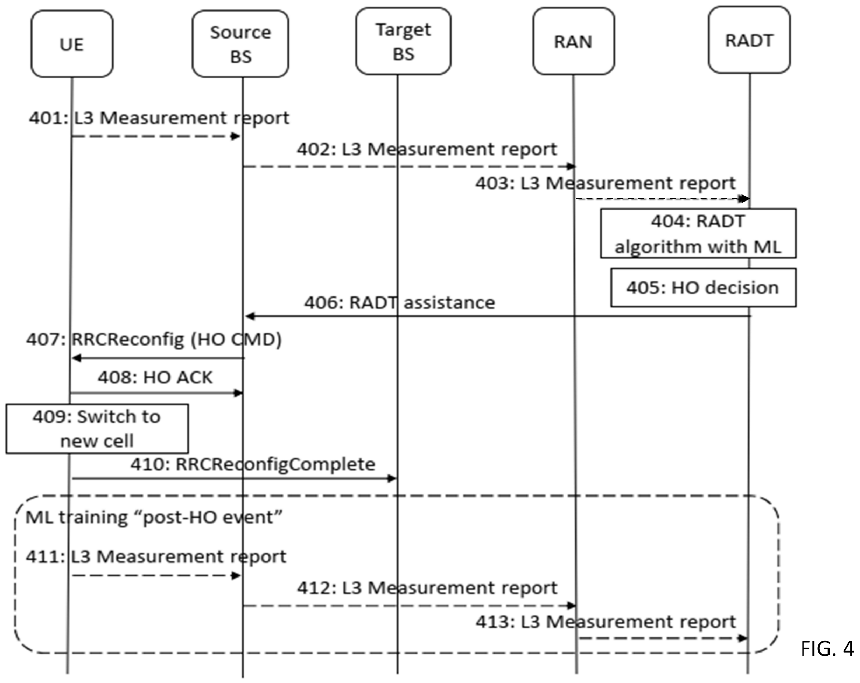

FIG. 4 illustrates a signal flow diagram according to an example embodiment. FIG. 4 illustrates an exemplary signalling flow to enable a digital twin command mode and digital twin commanded operation. The RADT node may give directly the command, e.g. HO command to the source BS. This may be beneficial especially in a very controlled and static environment, for example, in a factory with fixed UE trajectories.

Referring to FIG. 4, the terminal device UE, 100 may transmit to the RADT node via the source base station and the network node RAN, a measurement report 401, 402, 403, such as a layer-3 (L3) measurement report. At 404, the RADT node may perform a digital twin algorithm, such as a RADT algorithm; for example, machine learning (ML) and/or artificial intelligence (AI) may be used to learn the radio conditions at the location of the UE in the network. At 405, the RADT node may make a digital twin assistance decision, such as a handover decision. At 406, the RADT node may transmit to the source base station a digital twin command, such as a RADT command. At 407, the source base station may transmit to the terminal device UE, 100 a RRC reconfiguration message, such as a handover command. At 408, the terminal device UE, 100 may transmit to the source BS a digital twin acknowledgement message, such as a HO ack message. At 409, the terminal device UE, 100 may perform a RADT event, such as switching to a new cell by a handover. At 410, the terminal device may transmit to the target cell a RRC reconfiguration complete message, to complete the RADT event. After the RADT event, such as a HO event, the terminal device UE, 100 may transmit to the RADT node via the target base station and the network node RAN, a measurement report 411, 412, 413, such as a layer-3 (L3) measurement report, to perform post-event ML training.

The RADT assistance information element may comprise or consist of the following (which is just an example of the format and what type of information may be provided):

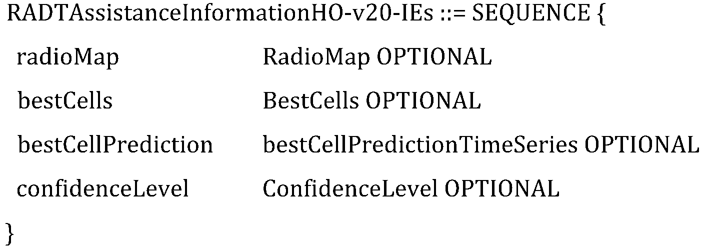

In the RADT assistance information element, "radioMap" may describe radio conditions in a geographical area, for example, on 5 x 5 m grid point. It may contain, for example, pathloss estimates from each cell for that grid point. It may also maintain other values, such as RSRQ8 SINR or even full estimated channel matrices H. The values may be provided from a planning tool, ray-tracer, via normal measurements, via dedicate measurements or, for example, via joint communication and sensing (JCAS), or any combination of those. ML/AI may be used to learn the radio conditions at a specific place in the network.

In the RADT assistance information element, "bestCells" may be a map which indicates the predicted best cell or candidate cell in certain position in the network.

In the RADT assistance information element, "bestCellPrediction" may be a prediction time series for the best cells or candidate cells in the future in at a certain location. This may enable the UE to use a scripted mode where the UE may independently move to a new cell based on the prediction in time and place.

In the RADT assistance information element, "confidenceLevel" may indicate how confident one may be of each information in the message, for example, the radio map data and/or best cell prediction. RAN may take this into account when deciding how much weight it is to put on this information in the decision making process.

For example, a radio map may be defined such that for each point (x,y) along the route on the map, the candidate cell or best serving cell may be: PCI_{best}(x,y) = argmax(RRSP(x,y)ᵢ). The RAN and/or UE may then receive this information from the digital twin and use the information for optimized handover with less signalling and measurements.

An embodiment enables to detect at least one candidate cell to which the handover is to be performed. An embodiment enables to detect an optimum time and optimum cell to perform the handover. For example, it may be detected that the handover to a new cell should be done earlier to avoid poor network quality during the route. An embodiment enables to improve the network performance by optimizing the handover performance based on more knowledge on the network, for example, knowledge on the environment where the UE is operating, knowledge on the buildings, vegetation, line-of-sight, etc.

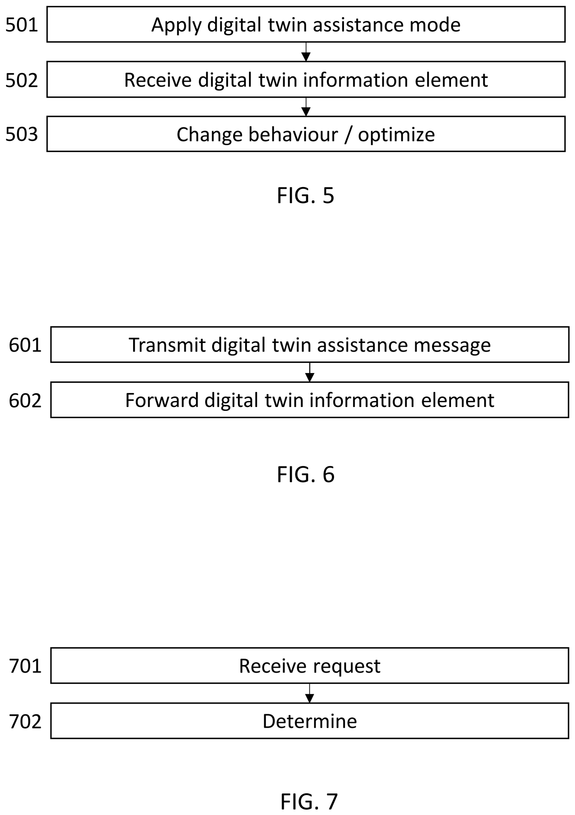

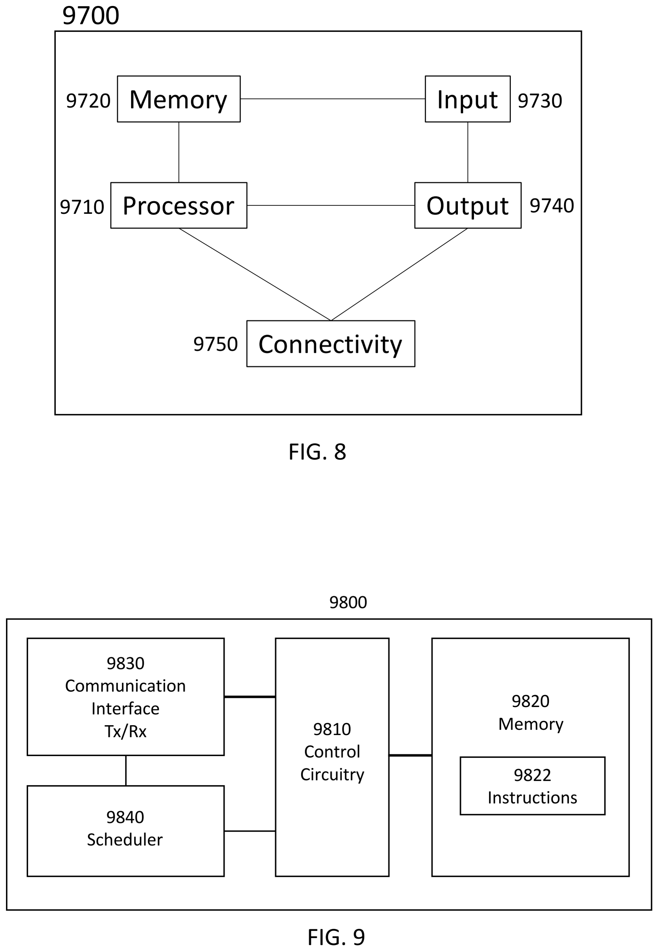

FIG. 5 illustrates a flow chart according to an example embodiment of a method for applying digital twin assistance. The method may be performed by an apparatus 9800 depicted in FIG. 9. For example, the apparatus 9800 may be, or comprise, or be comprised in, a network node 104, 105 of a radio access network.

In block 501, the apparatus 9800 may apply a digital twin assistance mode, based on a digital twin assistance message received by the apparatus from a network node 9900. In block 502, the apparatus 9800 may receive, from the network node 9900, a digital twin assistance information element. In block 503, the apparatus 9800 may, based on the digital twin assistance information element, change a default behaviour to cause a digital twin assisted behaviour in order to modify a network operation, wherein the digital twin assisted behaviour may represent an operation or a process associated with a digital twin assisted mode.

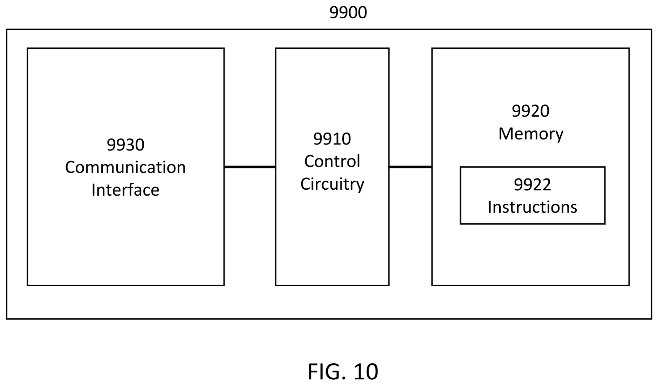

FIG. 6 illustrates a flow chart according to an example embodiment of a method for applying digital twin assistance. The method may be performed by an apparatus 9900 depicted in FIG. 10. For example, the apparatus 9900 may be, or comprise, or be comprised, a network function (e.g., AMF) 108 of the core network 110.

In block 601, the apparatus 9900 may transmit, to an apparatus 9800, a digital twin assistance message to request the apparatus 9800 to apply a digital twin assistance mode. In block 601, the apparatus 9900 may, upon the apparatus 9800 accepting to apply the digital twin assistance mode, forward, to the apparatus 9800, a digital twin assistance information element.

FIG. 7 illustrates a flow chart according to an example embodiment of a method for applying digital twin assisted mode. The method may be performed by an apparatus 9700 depicted in FIG. 8. For example, the apparatus 9700 may be, or comprise, or be comprised in, a user equipment (UE) 100, 102.

In block 701, the apparatus 9700 may receive, from an apparatus 9800, a request message requesting the apparatus 9700 to enter a digital twin assisted mode. In block 701, the apparatus 9700 may determine whether to enter the digital twin assisted mode enabling a digital twin assisted action parameter for the apparatus 9700.

Thus in an embodiment, an apparatus, such as a gNB or base station, may apply a digital twin assistance mode, based on a digital twin assistance message received by the apparatus from a network node, receive, from the network node, a digital twin assistance information element, and based on the digital twin assistance information element, change a default behaviour to cause a digital twin assisted behaviour in order to modify a network operation, wherein the digital twin assisted behaviour may represent an operation or a process associated with a digital twin assisted mode.

In an embodiment, the apparatus, such as a gNB or base station, may based on the digital twin assistance information element, transmit a request message to a terminal device, requesting the terminal device to enter a digital twin assisted mode, the digital twin assisted mode enabling a digital twin assisted handover, a digital twin assisted power control, a digital twin assisted resource allocation, a digital twin assisted beam selection, and/or other digital twin assisted action parameter, for the terminal device.

In an embodiment, the digital twin assistance information element comprises information on: a predicted at least one candidate cell for a digital twin assisted handover in a radio environment, and/or confidence level associated with the predicted at least one candidate cell, wherein the predicted at least one candidate cell is representative of a target cell for the digital twin assisted handover.

In an embodiment, the apparatus, such as a gNB or base station, may forward, to the terminal device, a request associated with a digital twin assisted handover, a request associated with a digital twin assisted power control, a request associated with a digital twin assisted resource allocation, and/or a request associated with a digital twin assisted beam selection.

In an embodiment, the apparatus, such as a gNB or base station, may forward, to the terminal device, a digital twin assisted handover command, upon a decision made by the apparatus to proceed with a digital twin assisted handover.

In an embodiment, the apparatus, such as a gNB or base station, may forward, to the terminal device, a digital twin assisted power control command, upon a decision made by the apparatus to proceed with a digital twin assisted power control.

In an embodiment, the apparatus, such as a gNB or base station, may forward, to the terminal device, a digital twin assisted resource allocation command, upon a decision made by the apparatus to proceed with a digital twin assisted resource allocation.

In an embodiment, the apparatus, such as a gNB or base station, may forward, to the terminal device, a digital twin assisted beam selection command, upon a decision made by the apparatus to proceed with a digital twin assisted beam selection.

In an embodiment, the apparatus, such as a gNB or base station, may make the decision based on information comprised in the digital twin assistance information element, and a current location of the terminal device.

In an embodiment, the apparatus, such as a gNB or base station, may decide and indicate to the network node, whether the apparatus accepts or declines the digital twin assistance mode.

In an embodiment, the apparatus may be a gNB, comprise the gNB, or be comprised in the gNB.

In an embodiment, a network node, such as an access network node, may transmit, to the apparatus, such as a gNB, a digital twin assistance message to request the apparatus to apply a digital twin assistance mode, and upon the apparatus accepting to apply the digital twin assistance mode, forward, to the apparatus, a digital twin assistance information element.

In an embodiment, the digital twin assistance information element comprises information on a predicted at least one candidate cell for a digital twin assisted handover in a radio network, and/or confidence level associated with the predicted at least one candidate cell, wherein the predicted at least one candidate cell is representative of a target cell for the digital twin assisted handover.

In an embodiment, the network node may forward, to the apparatus, a request associated with a digital twin assisted handover, a request associated with a digital twin assisted power control, a request associated with a digital twin assisted resource allocation, and/or a request associated with a digital twin assisted beam selection.

In an embodiment, the network node may forward, to the apparatus, a digital twin assisted handover command, upon a decision made by the network node to proceed with a digital twin assisted handover.

In an embodiment, the network node may forward, to the apparatus, a digital twin assisted resource allocation command, upon a decision made by the network node to proceed with a digital twin assisted resource allocation.

In an embodiment, the network node may forward, to the apparatus, a digital twin assisted power control command, upon a decision made by the network node to proceed with a digital twin assisted power control.

In an embodiment, the network node may forward, to the apparatus, a digital twin assisted beam selection command, upon a decision made by the network node to proceed with a digital twin assisted beam selection.

In an embodiment, the network node may make the decision based on information comprised in the digital twin assistance information element, and a current location of the terminal device.

In an embodiment, a terminal device may receive, from the apparatus, a request message requesting the terminal device to enter a digital twin assisted mode, determine whether to enter the digital twin assisted mode enabling a digital twin assisted action parameter for the terminal device.

In an embodiment, the terminal device may, while in the digital twin assisted mode, apply reduced downlink signal measurements and reduced downlink signal measurements reporting.

In an embodiment, the terminal device may, while in the digital twin assisted mode, perform a handover upon receiving a digital twin assisted handover command from the apparatus.

In an embodiment, the terminal device may, while in the digital twin assisted mode, perform a resource allocation upon receiving a digital twin assisted resource allocation command from the apparatus.

In an embodiment, the terminal device may, while in the digital twin assisted mode, perform a power control upon receiving a digital twin assisted power control command from the apparatus.

In an embodiment, the terminal device may, while in the digital twin assisted mode, perform a beam selection upon receiving a digital twin assisted beam selection command from the apparatus.

In an embodiment, there is provided a method which may comprise: transmitting, by a network node to an apparatus, a digital twin assistance message to request the apparatus to apply a digital twin assistance mode; and upon the apparatus accepting to apply the digital twin assistance mode, forwarding, by the network node to the apparatus, a digital twin assistance information element.

In an embodiment, there is provided a method which may comprise: receiving, by a terminal device from an apparatus, a request message requesting the terminal device to enter a digital twin assisted mode; and determining, by the terminal device, whether to enter the digital twin assisted mode enabling a digital twin assisted action parameter for the terminal device.

In an embodiment, there is provided a non-transitory computer readable medium comprising program instructions which, when executed by a network node, may cause the network node to perform at least the following: transmit, to an apparatus, a digital twin assistance message to request the apparatus to apply a digital twin assistance mode; and upon the apparatus accepting to apply the digital twin assistance mode, forward, to the apparatus, a digital twin assistance information element.

In an embodiment, there is provided a non-transitory computer readable medium comprising program instructions which, when executed by a terminal device, may cause the terminal device to perform at least the following: receive, from an apparatus, a request message requesting the terminal device to enter a digital twin assisted mode; and determine whether to enter the digital twin assisted mode enabling a digital twin assisted action parameter for the terminal device.

In an embodiment, there is provided a system comprising at least one processor and at least one memory storing instructions that, when executed by the at least one processor, cause the system to perform any the method steps.

The blocks, related functions, and information exchanges (messages) described above by means of FIGS. 2 to 7 are in no absolute chronological order, and some of them may be performed simultaneously or in an order differing from the described one. Other functions can also be executed between them or within them, and other information may be sent, and/or other rules applied. Some of the blocks or part of the blocks or one or more pieces of information can also be left out or replaced by a corresponding block or part of the block or one or more pieces of information.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

As used herein, the terms "the at least one" and "the one or more" mean "any one of the at least one" and "any one of the one or more", respectively.

FIG. 8 illustrates an example of an apparatus 9700 comprising means for causing the apparatus 9700 to perform one or more of the example embodiments (e.g., the method of FIG. 7) described above. For example, the apparatus 9700 may be an apparatus such as, or comprising, or comprised in, a user equipment (UE) 100, 102. The user equipment may also be called a wireless communication device, a subscriber unit, a mobile station, a remote terminal, an access terminal, a user terminal, a terminal device, or a user device.

The apparatus 9700 may comprise a circuitry or a chipset applicable for realizing one or more of the example embodiments described above. For example, the apparatus 9700 may comprise at least one processor 9710. The at least one processor 9710 interprets instructions (e.g., computer program instructions) and processes data. The at least one processor 9710 may comprise one or more programmable processors. The at least one processor 9710 may comprise programmable hardware with embedded firmware and may, alternatively or additionally, comprise one or more application-specific integrated circuits (ASICs).

The at least one processor 9710 is coupled to at least one memory 9720. The at least one processor is configured to read and write data to and from the at least one memory 9720. The at least one memory 9720 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The at least one memory 9720 stores computer readable instructions that are executed by the at least one processor 9710 to perform one or more of the example embodiments described above. For example, non-volatile memory stores the computer readable instructions, and the at least one processor 9710 executes the instructions using volatile memory for temporary storage of data and/or instructions. The computer readable instructions may refer to computer program code.

The computer readable instructions may have been pre-stored to the at least one memory 9720 or, alternatively or additionally, they may be received, by the apparatus, via an electromagnetic carrier signal and/or may be copied from a physical entity such as a computer program product. Execution of the computer readable instructions by the at least one processor 9710 causes the apparatus 9700 to perform one or more of the example embodiments described above. That is, the at least one processor and the at least one memory storing the instructions may provide the means for providing or causing the performance of any of the methods and/or blocks described above.

In the context of this document, a "memory" or "computer-readable media" or "computer-readable medium" may be any non-transitory media or medium or means that can contain, store, communicate, propagate or transport the instructions for use by or in connection with an instruction execution system, apparatus, or device, such as a computer. The term "non-transitory," as used herein, is a limitation of the medium itself (i.e., tangible, not a signal) as opposed to a limitation on data storage persistency (e.g., RAM vs. ROM).

The apparatus 9700 may further comprise, or be connected to, an input unit 9730. The input unit 9730 may comprise one or more interfaces for receiving input. The one or more interfaces may comprise, for example, at least one of: one or more temperature, motion and/or orientation sensors, one or more cameras, one or more accelerometers, one or more microphones, one or more buttons and/or one or more touch detection units. Further, the input unit 9730 may comprise an interface to which external devices may connect to.

The apparatus 9700 may also comprise an output unit 9740. The output unit may comprise or be connected to one or more displays capable of rendering visual content, such as a light emitting diode (LED) display, a liquid crystal display (LCD) and/or a liquid crystal on silicon (LCoS) display. The output unit 9740 may further comprise one or more audio outputs. The one or more audio outputs may be for example loudspeakers.

The apparatus 9700 further comprises a connectivity unit 9750. The connectivity unit 9750 enables wireless connectivity to one or more external devices. The connectivity unit 9750 comprises at least one transmitter and at least one receiver that may be integrated to the apparatus 9700 or that the apparatus 9700 may be connected to. The at least one transmitter comprises at least one transmission antenna, and the at least one receiver comprises at least one receiving antenna. The connectivity unit 9750 may comprise an integrated circuit or a set of integrated circuits that provide the wireless communication capability for the apparatus 9700. Alternatively, the wireless connectivity may be a hardwired application-specific integrated circuit (ASIC). The connectivity unit 9750 may also provide means for performing at least some of the blocks or functions of one or more example embodiments described above. The connectivity unit 9750 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

It is to be noted that the apparatus 9700 may further comprise various components not illustrated in FIG. 8. The various components may be hardware components and/or software components.

FIG. 9 illustrates an example of an apparatus 9800 comprising means for causing the apparatus 9800 to perform one or more of the example embodiments (e.g., the method of FIG. 5) described above. For example, the apparatus 9800 may be an apparatus such as, or comprising, or comprised in, a network node 104 of a radio access network.

The apparatus 9800 may comprise, for example, a circuitry or a chipset applicable for realizing one or more of the example embodiments described above. The apparatus 9800 may be an electronic device comprising one or more electronic circuitries. The apparatus 9800 may comprise a communication control circuitry 9810 such as at least one processor, and at least one memory 9820 storing instructions 9822 which, when executed by the at least one processor, cause the apparatus 9800 to carry out one or more of the example embodiments described above. Such instructions 9822 may, for example, include computer program code (software). The at least one processor and the at least one memory storing the instructions may provide the means for providing or causing the performance of any of the methods and/or blocks described above.

The processor is coupled to the memory 9820. The processor is configured to read and write data to and from the memory 9820. The memory 9820 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The memory 9820 stores computer readable instructions that are executed by the processor. For example, non-volatile memory stores the computer readable instructions, and the processor executes the instructions using volatile memory for temporary storage of data and/or instructions.

The computer readable instructions may have been pre-stored to the memory 9820 or, alternatively or additionally, they may be received, by the apparatus, via an electromagnetic carrier signal and/or may be copied from a physical entity such as a computer program product. Execution of the computer readable instructions causes the apparatus 9800 to perform one or more of the functionalities described above.

The memory 9820 may be implemented using any suitable data storage technology, such as semiconductor-based memory devices, flash memory, magnetic memory devices and systems, optical memory devices and systems, fixed memory and/or removable memory. The memory may comprise a configuration database for storing configuration data, such as a current neighbour cell list, and, in some example embodiments, structures of frames used in the detected neighbour cells.

The apparatus 9800 may further comprise or be connected to a communication interface 9830, such as a radio unit, comprising hardware and/or software for realizing communication connectivity with one or more wireless communication devices according to one or more communication protocols. The communication interface 9830 comprises at least one transmitter (Tx) and at least one receiver (Rx) that may be integrated to the apparatus 9800 or that the apparatus 9800 may be connected to. The communication interface 9830 may provide means for performing some of the blocks and/or functions (e.g., transmitting and receiving) for one or more example embodiments described above. The communication interface 9830 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

The communication interface 9830 provides the apparatus with radio communication capabilities to communicate in the wireless communication network. The communication interface may, for example, provide a radio interface to one or more UEs 100, 102. The apparatus 9800 may further comprise or be connected to another interface towards a core network 110, such as the network coordinator apparatus or AMF, and/or to other access nodes of the wireless communication network.

The apparatus 9800 may further comprise a scheduler 9840 that is configured to allocate radio resources. The scheduler 9840 may be configured along with the communication control circuitry 9810 or it may be separately configured.

It is to be noted that the apparatus 9800 may further comprise various components not illustrated in FIG. 9. The various components may be hardware components and/or software components.

FIG. 10 illustrates an example of an apparatus 9900 of a core network 110, the apparatus 9900 comprising means for causing the apparatus 9900 to perform one or more of the example embodiments (e.g., the method of FIG. 6) described above. For example, the apparatus 9900 may be, or comprise, or be comprised, a network function (e.g., AMF) of the core network 110.

The apparatus 9900 may comprise, for example, a circuitry or a chipset applicable for realizing one or more of the example embodiments described above. The apparatus 9900 may be an electronic device or computing system comprising one or more electronic circuitries. The apparatus 9900 may comprise a control circuitry 9910 such as at least one processor, and at least one memory 9920 storing instructions 9922 which, when executed by the at least one processor, cause the apparatus 9900 to carry out one or more of the example embodiments described above. Such instructions 9922 may, for example, include computer program code (software). The at least one processor and the at least one memory storing the instructions may provide the means for providing or causing the performance of any of the methods and/or blocks described above.

In another embodiment, the means may be a network function of the core network 110, or the means may be network function virtualization infrastructure.

The processor is coupled to the memory 9920. The processor is configured to read and write data to and from the memory 9920. The memory 9920 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The memory 9920 stores computer readable instructions that are executed by the processor. For example, non-volatile memory stores the computer readable instructions, and the processor executes the instructions using volatile memory for temporary storage of data and/or instructions.

The computer readable instructions may have been pre-stored to the memory 9920 or, alternatively or additionally, they may be received, by the apparatus, via an electromagnetic carrier signal and/or may be copied from a physical entity such as a computer program product. Execution of the computer readable instructions causes the apparatus 9900 to perform one or more of the functionalities described above.

The memory 9920 may be implemented using any suitable data storage technology, such as semiconductor-based memory devices, flash memory, magnetic memory devices and systems, optical memory devices and systems, fixed memory and/or removable memory.

The apparatus 9900 may further comprise or be connected to a communication interface 9930 comprising hardware and/or software for realizing communication connectivity according to one or more communication protocols. The communication interface 9930 may comprise at least one transmitter (Tx) and at least one receiver (Rx) that may be integrated to the apparatus 9900 or that the apparatus 9900 may be connected to. The communication interface 9930 may provide means for performing some of the blocks and/or functions (e.g., transmitting and receiving) for one or more example embodiments described above. The communication interface 9930 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

The communication interface 9930 provides the apparatus with communication capabilities to communicate in the wireless communication network. The communication interface 9930 may, for example, provide a radio, cable or fiber interface to one or more network nodes of a radio access network.

It is to be noted that the apparatus 9900 may further comprise various components not illustrated in FIG. 10. The various components may be hardware components and/or software components.

As used in this application, the term "circuitry" may refer to one or more or all of the following: a) hardware-only circuit implementations (such as implementations in analog, digital and/or quantum circuitry); and b) combinations of hardware circuit(s) and software, such as (as applicable): i) a combination of analog, digital and/or quantum hardware circuit(s) with software/firmware and ii) any or all portions of hardware processor(s) (including digital and/or quantum processor(s)) with software, and memory(ies) that work together to cause an apparatus, such as a mobile device, computing device, or server, to perform various functions; and c) any or all portions of hardware circuit(s), such as microprocessor(s), processor(s) and/or quantum processor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

The techniques and methods described herein may be implemented by various means. For example, these techniques may be implemented in hardware (one or more devices), firmware (one or more devices), software (one or more modules), or combinations thereof. For a hardware implementation, the apparatus(es) of example embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (for example procedures, functions, and so on) that perform the functions described herein. The software codes may be stored in a memory unit and executed by processors. The memory unit may be implemented within the processor or externally to the processor. In the latter case, it can be communicatively coupled to the processor via various means, as is known in the art. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

It will be understandable to a person skilled in the art that, as technology advances, the proposed concept may be implemented in various ways within the scope of the claims. The embodiments are not limited to the example embodiments described above but may vary within the scope of the claims. Therefore, all words and expressions should be interpreted broadly, and they are intended to illustrate, not to restrict, the embodiments.

## Claims

1. An apparatus comprising at least one processor, and at least one memory storing instructions that, when executed by the at least one processor, cause the apparatus at least to:
apply a digital twin assistance mode, based on a digital twin assistance message received by the apparatus from a network node;
receive, from the network node, a digital twin assistance information element; and
based on the digital twin assistance information element, change a default behaviour to cause a digital twin assisted behaviour in order to modify a network operation, wherein the digital twin assisted behaviour represents an operation or a process associated with a digital twin assisted mode.

2. The apparatus according to claim 1, being caused to:
based on the digital twin assistance information element, transmit a request message to a terminal device, requesting the terminal device to enter the digital twin assisted mode,
the digital twin assisted mode enabling a digital twin assisted handover, a digital twin assisted power control, a digital twin assisted resource allocation, a digital twin assisted beam selection, and/or other digital twin assisted action parameter, for the terminal device.

3. The apparatus according to claim 1 or claim 2, wherein
the digital twin assistance information element comprises information on: a predicted at least one candidate cell for a digital twin assisted handover in a radio environment, and/or confidence level associated with the predicted at least one candidate cell,
wherein the predicted at least one candidate cell is representative of a target cell for the digital twin assisted handover.

4. The apparatus according to any one of claims 1 to 3, being caused to:
forward, to the terminal device, a request associated with a digital twin assisted handover, a request associated with a digital twin assisted power control, a request associated with a digital twin assisted resource allocation, and/or a request associated with a digital twin assisted beam selection.

5. The apparatus according to claim 4, being caused to:
forward, to the terminal device, a digital twin assisted handover command, based upon a decision made by the apparatus to proceed with the digital twin assisted handover; and/or
forward, to the terminal device, a digital twin assisted power control command, based upon a decision made by the apparatus to proceed with the digital twin assisted power control; and/or
forward, to the terminal device, a digital twin assisted resource allocation command, based upon a decision made by the apparatus to proceed with the digital twin assisted resource allocation; and/or
forward, to the terminal device, a digital twin assisted beam selection command, based upon a decision made by the apparatus to proceed with the digital twin assisted beam selection.

6. The apparatus according to any of the preceding claims, wherein the apparatus is a gNB, comprises the gNB, or is comprised in the gNB.

7. A network node comprising at least one processor, and at least one memory storing instructions that, when executed by the at least one processor, cause the network node at least to:
transmit, to an apparatus, a digital twin assistance message to request the apparatus to apply a digital twin assistance mode; and
based upon the apparatus accepting to apply the digital twin assistance mode,
forward, to the apparatus, a digital twin assistance information element.

8. The network node according to claim 7, being caused to:
forward, to the apparatus, a request associated with a digital twin assisted handover, a request associated with a digital twin assisted power control, a request associated with a digital twin assisted resource allocation, and/or a request associated with a digital twin assisted beam selection.

9. The network node according to claim 7 or claim 8,
wherein the digital twin assistance information element comprises information on a predicted at least one candidate cell for a digital twin assisted handover in a radio network, and/or confidence level associated with the predicted at least one candidate cell,
wherein the predicted at least one candidate cell is representative of a target cell for the digital twin assisted handover.

10. The network node according to any one of claims 7 to 9, being caused to:
forward, to the apparatus, a digital twin assisted handover command, upon a decision made by the network node to proceed with a digital twin assisted handover; and/or
forward, to the apparatus, a digital twin assisted resource allocation command, upon a decision made by the network node to proceed with a digital twin assisted resource allocation; and/or
forward, to the apparatus, a digital twin assisted power control command, upon a decision made by the network node to proceed with a digital twin assisted power control; and/or
forward, to the apparatus, a digital twin assisted beam selection command, upon a decision made by the network node to proceed with a digital twin assisted beam selection.

11. A terminal device comprising at least one processor, and at least one memory storing instructions that, when executed by the at least one processor, cause the terminal device at least to:
receive, from an apparatus, a request message requesting the terminal device to enter a digital twin assisted mode;
determine whether to enter the digital twin assisted mode enabling a digital twin assisted action parameter for the terminal device.

12. The terminal device according to claim 11, being caused to:
while in the digital twin assisted mode, apply reduced downlink signal measurements and reduced downlink signal measurements reporting.

13. The terminal device according to claim 11 or claim 12, being caused to:
while in the digital twin assisted mode,
perform a handover upon receiving a digital twin assisted handover command from the apparatus;
perform a resource allocation upon receiving a digital twin assisted resource allocation command from the apparatus;
perform a power control upon receiving a digital twin assisted power control command from the apparatus; and/or
perform a beam selection upon receiving a digital twin assisted beam selection command from the apparatus.

14. A method comprising:
applying, by an apparatus, a digital twin assistance mode, based on a digital twin assistance message received by the apparatus from a network node;
receiving, by the apparatus from the network node, a digital twin assistance information element; and
based on the digital twin assistance information element, changing, by the apparatus, a default behaviour to cause a digital twin assisted behaviour in order to modify a network operation, wherein the digital twin assisted behaviour represents an operation or a process associated with a digital twin assisted mode.

15. A non-transitory computer readable medium comprising program instructions which, when executed by an apparatus, cause the apparatus to perform the method of claim 14.
